# EUROPÄISCHE PATENTSCHRIFT

(11) **EP 1 863 946 B1**
(45) Veröffentlichungstag und Bekanntmachung des Hinweises auf die Patenterteilung: **17.04.2013**
(21) Anmeldenummer: 06705417.1
(22) Anmeldetag: 28.03.2006
(51) Int. Cl.: C23C 14/06, C23C 30/00, C23C 28/00

(54) **MEHRLAGIGE HARTSTOFFBESCHICHTUNG FÜR WERKZEUGE**
MULTI-LAYERED HARD MATERIAL COATING FOR TOOLS
REVETEMENT EN MATIERE DURE MULTICOUCHE POUR OUTILS

(30) Priorität: 01.04.2005 CH 598052005
(43) Veröffentlichungstag der Anmeldung: 12.12.2007
(73) Patentinhaber: Oerlikon Trading AG, Trübbach, 9477 Trübbach (CH)
(72) Erfinder: DERFLINGER, Volker, A-6800 Feldkirch (AT)
(74) Vertreter: Troesch Scheidegger Werner AG
(86) Internationale Anmeldenummer: PCT/CH2006/000177
(87) Internationale Veröffentlichungsnummer: WO 2006/102780

(56) Entgegenhaltungen:
- EP-A- 1 174 528
- EP-A- 1 422 311
- CA-A1- 2 523 882

## Beschreibung

### Technisches Gebiet

Die vorliegende Erfindung bezieht sich auf mehrlagige Hartstoffbeschichtung für Werkzeugen (Hartmetall und Schnellarbeitsstahl) für Zerspanungsanwendungen - im Speziellen für Bohranwendungen.
1 a) Hartstoffbeschichtete Werkstücke, mit einer Abfolge mehrere unterschiedlicher Aluminiumchromnitrid, bzw. -carbonitrid und Titansiliciumnitrid, bzw. -carbonitrid Schichten.
1 b) Werkzeuge, insbesondere Schneid- und Umformwerkzeuge (Bohrer, Fräser, Gewindebohrer, -former, Abwälzfräser, Stempel, Matritzen, Ziehstempel, etc.) mit einer Abfolge mehrerer unterschiedlicher Aluminiumchromnitrid, bzw. -carbonitrid und Titansiliciumnitrid, bzw. -carbonitrid Schichten sowie die Anwendung dieser Werkzeuge.
1 c) Ein Verfahren zur Herstellung von einer Abfolge mehrerer unterschiedlicher Aluminiumchromnitrid, bzw. -carbonitrid und Titansiliciumnitrid, bzw. -carbonitrid Schichten mit definierter Schichtstruktur.

### Stand der Technik

EP 1174528 A2 beschreibt eine aus einer Abfolge mehrerer Einzelschichten bestehende Beschichtung auf Werkzeugen, wobei eine erste Schicht aus einem Nitrid, Karbid, Karbonitrid, Borid, Oxid, etc. der Elemente Ti, Al und/oder Cr besteht, und eine zweite Schicht aus einem Nitrid, Karbid, Karbonitrid, Borid, Oxid, etc. des Si und mindestens einem Element aus den Gruppen 4a, 5a und 6a des PSE. Der Vorteil dieser Beschichtung wird damit angegeben, dass durch das Si in der oberen Schicht die Verschleissbeständigkeit und die Oxidationsbeständigkeit gravierend verbessert werden. Vor allem Deckschichten auf Cr-Si-Basis zeigten Verbesserungen in der Standzeit. Als Unterschicht wurden TiAlN-, CrAlN- und TiN-Schichten gewählt.

In EP 1422311 A2 werden Hartstoffschichten auf Al-Cr-(Si)-O-Basis beschrieben, die als Nitride, Karbid, Oxid, Borid, etc. ausgebildet sein können. Für alle Schichten gilt, dass ein geringer Sauerstoffanteil (1-25at%) in den Schichten enthalten ist. Zusätzlich wird erwähnt, dass eine weitere Hartstoffschicht auf der in der Erfindung erwähnten Beschichtung aufgetragen sein kann. Als Beispiele werden hier unter anderen Ti-Si-N, Ti-B-N, BN, Cr-Si-N, etc. angegeben. Als Vorteil für diese Erfindung wird hier vor allem der Einbau von geringen Mengen an Sauerstoff oder Silizium und Sauerstoff angegeben, da dies zu einer höheren Härte sowie einer verbesserten Verschleiss- und Hochtemperatur-Oxidationsbeständigkeit führt.

In EP 1219723 A2 wird eine Beschichtung auf Ti-Al-Cr-X-N-Basis vorgestellt, wobei X für Si, B und/oder C stehen kann. Der Vorteil dieser Beschichtung wird in der Verbesserung der Verschleissbeständigkeit gegenüber konventionellen Beschichtungen angegeben. Weiters wird in der Erfindung ein Target beschrieben, dass zumindest aus Ti, Al und Cr bestehen muss.

### Nachteile des Standes der Technik

Hartstoffbeschichtete Werkzeuge gemäss Stand der Technik (Ti-Al-N-basierte Beschichtungen) weisen geringere Standzeiten als die neuen optimierten (Al₁₋ₓCrₓX)-(Ti_{1-y}Sᵢy) X - Hartstoffschichten für X = N bzw. CN.

Die Nachteile des Stands der Technik zeigen weiters, dass bei Al-Cr-N-Beschichtungen bei höheren Temperaturen unter Inertgasatmosphäre (zB: Argonatmosphäre) eine Zersetzung der Beschichtung schon bei rund 900°C beginnt. Führt man diesen Wärmebehandlungsprozess unter Sauerstoffatmosphäre durch, verschiebt sich dieser Zerfallsprozess zu einem höheren Temperaturbereich. Wenn man nun in der Zerspanung einen kontinuierlichen Schnitt betrachtet, kommt es in der Kontaktfläche zwischen Werkzeugoberfläche und dem Werkstück örtlich zu sehr hohen Temperaturen (teilweise über 1000°C). Wenn nun diese Kontaktfläche gross genug ist, so dass kein/wenig Sauerstoff an der Beschichtungsoberfläche stabilisierend wirken kann, zerfällt das kubische CrN in hexagonales Cr₂N und in weiterer Folge bei noch höherer Temperatur zu metallischem Cr. Dieser Zersetzungsprozess der Beschichtung führt zu einem verfrühten Verschleiss der Beschichtung im Einsatz der sich insbesondere als Kolkverschleiss ausbildet.

### Aufgabenstellung der vorliegenden Erfindung

Die vorliegende Erfindung soll die Nachteile des Standes der Technik vermeiden und dient insbesondere einer Verbesserung der Standzeit beschichteter Werkstücke, wie zum Beispiel Zerspanungswerkzeuge, Schneid- & Formwerkzeuge bzw. Bauteile für den Maschinen- & Formenbau. Weiters ist es Aufgabe der vorliegenden Erfindung, ein Verfahren zum Abscheiden solcher Schichten zur Verfügung zu stellen, insbesondere zum Abscheiden solcher Schichten auf besagten Werkstücken.

### Angabe der Lösung bzw. des Lösungsweges

Die Aufgabe wird erfindungsgemäss gelöst durch ein Hartstoffbeschichtung nach Anspruch 1 bzw. ein Werkzeug mit iner solchen Beschichtung nach Anspruch 12. Weitere erfinderische Ausformungen sind in den Unteransprüchen beschrieben.

Die Erfindung beschreibt einen speziellen Mehrschichtaufbau einer Beschichtung, der einen vorschnellen Zerfall (Verschleiss) der Beschichtung während des Einsatzes verhindern soll. Durch den Mehrlagenaufbau werden der Zerfall und die nachfolgende Diffusion des CrN-Anteils innerhalb der AlCrN-Beschichtung bei höheren Temperaturen verhindert oder zumindest verzögert.
Zur Abscheidung der Al-Cr-(X)-N/Ti-Si-N-Hanschichten wurde eine industrielle Beschichtungsanlage vom Typ RCS der Firma Balzers herangezogen, wie sie beispielsweise auch in EP 1186681 in Fig. 3 bis 6, Beschreibung Spalte 7, Zeile 18, bis Spalte 9, Zeile 25, beschrieben ist. Dazu wurden die gereinigten Werkstücke je nach Durchmesser auf zwei- bzw. für Durchmesser kleiner 50 mm auf dreifach rotierende Substratträger befestigt und zwei schmelzmetallurgisch hergestellte Ti-Si-Targets und vier pulvermetallurgisch hergestellte Targets aus Al-Cr-(X)-Legierungen in sechs an den Wänden der Beschichtungsanlage angebrachten kathodischen Arcquellen eingebaut. Die Geometrie der Targetanordnung ist dabei im wesentlichen durch den achteckigen Grundriss der RCS-Anlage bestimmt, bei der zwei gegenüber angeordnete Heizsegmente zwei Gruppen von drei aufeinanderfolgenden mit jeweils einer Arckathode bestückte Segmente trennt. Für die vorliegenden Versuche wurde jeweils ein SiTi-Target im gegenüberliegenden Mittelelement jeder Dreiergruppe eingebaut. Es sind jedoch auch andere Targetanordnungen möglich, um solche Schichten herzustellen. Prinzipiell können solche Schichten in jeder Anlage, die zumindest zwei Arckathoden in geometrisch äquivalenter Position, z.B. auf derselben Beschichtungshöhe eines einfach oder mehrfach rotierenden Substrathalters, aufweist, abgeschieden werden. Dem Fachmann ist bekannt, wie er je nach Anlagentyp die Schichtdicke der einzelnen Schichten bzw. Lagen durch Anordnung der Targets bzw. Einstellung der jeweiligen Substratbewegung bzw. drehung oder der Winkelgeschwindigkeit einer Werkstückrotation weiter beeinflussen kann.

Anschließend wurden zunächst die Werkstücke durch ebenfalls in der Anlage angebrachte Strahlungsheizungen auf eine Temperatur von ca. 500°C gebracht und im Folgenden die Oberfläche durch Anlegen einer DC-Biasspannung von -100 bis -200 V unter Ar-Atmosphäre bei einem Druck von 0,2 Pa einer Ätzreinigung durch Ar-Ionen unterzogen.

Im Folgenden wurde durch Betrieb von vier Al-Cr-Quellen mit einer Leistung von 3 kW und Anlegen eines Substratbias von -50 V während einer Zeit von ca. 5 Minuten eine ca. 0.2 µm dicke Al-Cr-N-Haftschicht abgeschieden. Anschliessend wurde gezielt eine Mehrfachbeschichtung aufgebaut, bei der zuerst zu den 4 Al-Cr-Quellen zusätzlich 2 Ti-Si-Quellen mit ebenfalls jeweils 3 kW dazugeschaltet und für eine Dauer von ca. 1 Minute gemeinsam betrieben werden. Anschliessend werden die 4 Al-Cr-Quellen abgeschaltet und es wird eine reine Ti-Si-N-Beschichtung für ca. 3 Minuten abgeschieden. Dann werden wieder die 4 Al-Cr-Quellen für ca. 1 Minute dazugeschaltet. In weiterer Folge werden die Ti-Si-Quellen wieder abgeschaltet und eine reine Al-Cr-N-Beschichtung für weitere 5 Minuten abgeschieden. Diese Abfolge für das Schichtpaket wird im Rahmen der Erfindung mehrmals während der Abscheidung durchlaufen. Abschliessend wird noch eine Deckschicht, die ausschliesslich mit den Ti-Si-Quellen hergestellt wird, mit einer Dicke von etwa 0.5 µm aufgebracht. Alternativ kann hierbei auch eine dickere AlCrN-Deckschicht aufgebracht werden. Alle Schichten wurden in reiner Stickstoffatmosphäre bei einem Druck von rund 3 Pa und einer negativen Substratvorspannung von etwa 50 Volt abgeschieden. Grundsätzlich kann der Prozessdruck bei jedem dieser Schritte in einem Bereich von 0.5 bis rund 8 Pa, bevorzugt aber zwischen 0.8 und 5 Pa eingestellt werden, wobei entweder eine reine Stickstoffatmosphäre oder eine Mischung aus Stickstoff und einem Edelgas, wie z.B. Argon, für nitridische Schichten, bzw. eine Mischung aus Stickstoff und einem kohlenstoffhaltigen Gas, der bei Bedarf ein Edelgas zugemischt werden kann, für carbonitridische Schichten verwendet. Dementsprechend kann für die Abscheidung sauerstoff- bzw. borhaltiger Schichten Sauerstoff bzw. ein borhaltiges Gas wie bekannt zugemischt werden.

Targetzusammensetzung, Kristallstruktur der Schicht und Haftung sind in Tabelle 1 dargestellt. Prozessparameter wie Targetleistung, negative Substrätvorspännung, Prozessdruck und Temperatur sind in Tabelle 2 zusammengefasst.

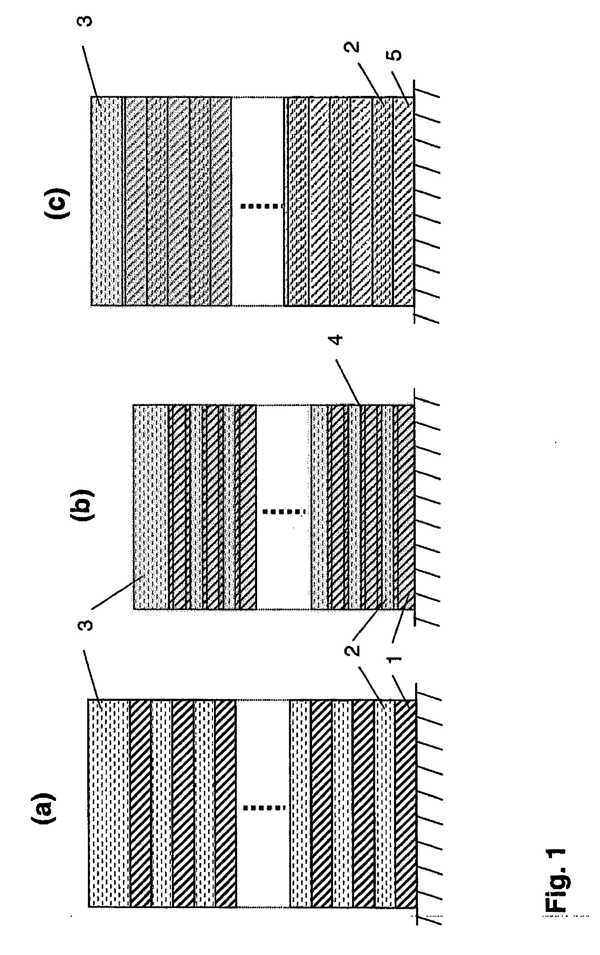

Erfindungsgemässe Werkstücke zeichnen sich dadurch aus, dass eine kubische (Al_{y}Cr_{1-y}) X Beschichtung mit X = N bzw. CN, bevorzugt aber N, und 0.2 ≤ y < 0.7, bevorzugt 0.3 ≤ y ≤ 0.5 alternierend mit einer kubischen (Ti_{z}Si_{1-z}) X Beschichtung mit X = N bzw. CN, bevorzugt aber N, und 0.99 ≥ z > 0.7, bevorzugt 0.97 ≥ z ≥ 0.85 abgeschieden wird (Siehe Fig. 1a), wobei zumindest ein Schichtpaket und zumindest eine zusätzliche (Al_{y}Cr_{1-y}) X bzw. (Ti_{z}Si_{1-z}) X-Schicht aufgebracht wird. Die Schichtstruktur ist dabei in beiden Schichten mikrokristallin mit einer mittleren Korngrösse von ca. 5 - 150 nm, bevorzugt aber von ca. 10 - 120 nm. Vorteilhaft für die Beschichtung sind zusätzliche Zwischenschichten zwischen den reinen (A-l_{y}Cr_{1-y}) X- und den (Ti_{z}Si_{1-z}) X-Schichten, bei denen alle Beschichtungsquellen laufen und somit eine (Al_{y}Cr_{1-y}Ti_{z}Si_{1-z}) X-Schicht abgeschieden wird (Siehe Fig. 1b). Diese Zwischenschichten können bei Bedarf, je nach Abfolge bzw. Zusammensetzung und Eigenschaften der einzelnen Schichtsysteme, eine verbesserte Haftung zwischen den einzelnen Schichten bewirken. Wegen der geometrischen Targetanordnung innerhalb der Beschichtungsanlage wird aufgrund der Werkstückrotation während der Abscheidung dieser Zwischenschicht zusätzlich eine Multilagen-Struktur mit sehr feinen Lagen abgeschieden, da nach wie vor Einzeltargets auf Al-Cr- und Ti-Si-Basis für die Beschichtung herangezogen werden. Die Einzellagenbreite innerhalb dieser Zwischenschicht bewegt sich im Bereich von wenigen Nanometern.

Eine weitere Möglichkeit das gewünschte Mehrschichtsystem aufzubauen, kann durch periodisches Zu- bzw. Abschalten von Beschichtungsquellen analog zu Fig. 1c durchgeführt werden. Hier laufen die Beschichtungsquellen für ein Beschichtungsmaterial während des gesamten Abscheidevorgangs, während die Beschichtungsquellen mit dem zweiten Beschichtungsmaterial periodisch dazugeschaltet werden. In diesem Fall kann während des gemeinsamen Betriebs der Arcquellen eine wie oben erwähnte zusätzliche Multilagenstruktur erzeugt werden.

Die erfindungsgemässen Verfahren zeichnen sich dadurch aus, dass eine Verfahrensführung gewählt wird, um das oben beschriebene Schichtpaket abzuscheiden. Die Vielschichtstruktur wird durch gezieltes Ein- bzw. Ausschalten von den Beschichtungsquellen erreicht. Die Multilagen-Substruktur wird zusätzlich durch Rotation bzw. Bewegung der zu beschichtenden Werkstücke innerhalb der Beschichtungsanlage erhalten.

In Beispiel 1 werden Beschichtungen mit einer definierten Anzahl an Schichten bzw. Schichtpaketen gegenübergestellt, wobei ein Schichtpaket jeweils aus einer Schichtabfolge aus einer AICrTiSiN- gefolgt von einer TiSiN-, einer AICrTiSiN- sowie einer AlCrN-Schicht besteht. Es ist klar erkennbar, dass gegenüber der in Experiment Nr.1 getesteten Schicht, die gemäss Stand der Technik abgeschieden wurde, mit der erfindungsgemässen Beschichtung eine Verbesserung der Standzeit erreicht werden kann. Auch ist erkennbar, dass eine optimale Schichtdicke der Einzelschichten aus Al_{y}Cr_{1-y}N und Ti_{z}Si_{1-z}N für die benötitge Standzeiterhöhung wichtig ist. Diese Schichtdicke liegt bei Al_{y}Cr_{1-y}N zwischen 75 nm und 200 nm, bevorzugt bei 120 nm bis 170 nm, und bei Ti_{z}Si_{1-z}N zwischen 50 und 150 nm, bevorzugt zwischen 70 bis 120 nm. Im Rahmen dieses Beispiels wurden diese Schichtdicken über die Beschichtungszeit so verändert, dass für alle Experiment eine vergleichbare Gesamtschichtdicke von etwa 4 µm erhalten werden konnte. Für diese Experimente wurde ein Schichtaufbau gewählt, wie er in Fig.1b beschrieben wurde. Die Schichten, bei denen alle Beschichtungsquellen im Einsatz waren, wurden für die jeweiligen Experimente nicht verändert und ergaben eine Einzelschichtdicke von jeweils rund 20 ±10 nm.

Grundsätzlich können mit derartigen Al_{y}Cr_{1-y}N/Ti_{z}Si_{1-z}N-Multilagenschichten ganz unterschiedliche Werkstücke vorteilhaft beschichtet werden. Beispiele dafür sind Schneidwerkzeuge wie Fräser, Abwälzfräser, Kugelkopf-, Planar- und Profilfräser, sowie Bohrer, Gewindebohrer, Räumwerkzeuge, Reibahlen und Wendeschneidplatten für Dreh- und Fräsbearbeitungen bzw. Umformwerkzeuge wie beispielsweise Stempel, Matrizen, Ziehringe, Auswurfkerne oder Gewindeformer. Auch Spritzgusswerkzeuge beispielsweise für metallische Spritzgusslegierungen, Kunstharze oder thermoplastische Kunststoffe, insbesondere Spritzgusswerkzeuge wie sie zum Herstellen von Kunststoffformteilen bzw. Datenträgern wie CD's, DVD's u.a. verwendet werden, können vorteilhaft mit derartigen Schichten geschützt werden. Wenn auch durch erfindungsgemässe Beschichtungen nicht für alle Anwendungen auf unterschiedlichen Werkzeugen immer bessere Ergebnisse erzielt werden, so kann doch zumindest bei bestimmten Anwendungen, wie auch in den Beispielen angeführt, eine wesentlich höhere Verschleissfestigkeit als mit bisher bekannten Schichten erreicht werden.

Weiters ist auf Grund des prinzipiell ähnlichen Verhaltens von Al_{y}Cr_{1-y}X/Ti_{z}Si_{1-z}X-Multilagenschichten auch eine Verbesserung des Verschleissverhaltens zu erwarten, wenn bei folgenden Schichtsystemen Targetzusammensetzungen und Beschichtungs-parameter so gewählt werden, dass X = N, C, B, CN, BN, CBN, NO, CO, BO, CNO, BNO, CBNO bevorzugt aber N bzw. CN und 0.2 ≤ y ≤ 0.7, bevorzugt 0.40 ≤ y ≤ 0.68, und 0.99 ≥ z > 0.7, bevorzugt 0.95 ≥ z ≥ 0.85, ist.

Eine Möglichkeit die Schichteigenschaften des Al_{y}Cr_{1-y}NlTi_{z}Si_{1-z}N-Multilagenschichten zu verbessern, besteht in der Zulegierung von weiteren chemischen Elementen aus einer oder mehreren Gruppen der Gruppen IVb, Vb und/oder VIb des Periodensystems der Elemente, bzw. von Silizium. Insbesondere vorteilhaft kann das Zulegieren innerhalb des Lagenpakets der Al_{y}Cr_{1-y-m}MₘN-Schicht sein, mit 0 ≤ m ≤ 0.25, bevorzugt 0 ≤ m ≤ 0.15. Vorteilhaft haben sich vor allem die Elemente für M = W, V, Mo, Nb und Si gezeigt (Siehe dazu Beispiel Nr. 5).

Eine weitere Möglichkeit die Schichteigenschaften des Schichtsystems zu verbessern besteht in der Aufbringung einer zusätzlichen Gleitschicht auf das Schichtpaket oder auf die, die Hartstoffschicht nach Aussen abschliessende, Deckschicht. Das Gleitschichtsystem, kann dabei aus mindestens einem Metall oder einem Karbid mindestens eines Metalles und dispersem Kohlenstoff, MeC/C aufgebaut sein, wobei das Metall ein Metall der Gruppe IVb, Vb und/oder Vlb und/oder Silizium ist. Beispielsweise eignet sich hierfür besonders eine WC/C-Deckschicht mit einer zwischen 1000 und 1500 HV einstellbaren Härte, die ausgezeichnete Einlaufeigenschaften aufweist. Auch CrC/C-Schichten zeigen ein ähnliches Verhalten, bei einem allerdings etwas höheren Reibkoeffizienten.

Bei derartig beschichteten Tieflochbohrern konnte nach Herstellung von einem Bohrloch bereits eine zusätzliche Einlaufglättung der Spanflächen festgestellt werden, die bis jetzt nur durch eine aufwändige mechanische Bearbeitung erzielt wird. Diese führt zu einer Verbesserung des Spantransportes entlang der Spannut und zu einer Minimierung des Reibmoments während dem Bohrvorgang. Interessant sind solche Eigenschaften auch besonders für Bauteilanwendungen mit Gleit-, Reib- bzw. Rollbeanspruchung, insbesondere unter Mangelschmierung oder Trockenlauf, oder wenn gleichzeitig ein unbeschichteter Gegenkörper geschützt werden soll.

Weitere Möglichkeiten zur Bildung einer abschliessenden Gleitschicht sind metallfreie diamantähnlichen Kohlenstoffschichten, bzw. eine MoSₓ-, WSₓ- oder titanhaltige MoSₓ- bzw. MoWₓ-Schichten.

Die Gleitschicht kann dabei, wie erwähnt, direkt auf das Mehrschichtsystem oder nach Aufbringen einer weiteren Haftschicht aufgebracht werden, um eine möglichst gute Haftung des Schichtverbunds zu bewirken. Die Haftschicht kann dabei metallisch, nitridisch, carbidisch, carbonitridisch oder auch als Gradientenschicht ausgeführt sein.

Beipielsweise können WC/C- bzw. CrC/C-Schichten nach Aufbringen einer gesputterten oder gearcten Cr- bzw. Ti-Haftschicht vorteilhaft durch Sputtern von WC-Targets unter Zugabe eines kohlenstoffhaltigen Gases hergestellt werden. Dabei wird der Anteil des kohlenstoffhaltigen Gases mit der Zeit erhöht um eine grösseren Anteil an freien Kohlenstoff in der Schicht zu erzielen.

### Weitere vorteilhafte Wirkungen der Erfindung

Im Folgenden werden für die Erfindung vorteilhafte Anwendungen beispielhaft am Einsatz für verschiedene Schneidoperationen dargestellt.

### Beispiel 1:

Bohren mit innengekühlten HM-Bohrern in Baustahl
- Werkzeug:: Bohrer Hartmetall mit Kühlkanälen Durchmesser D = 6.8 mm
- Werkstück:: Baustahl DIN 1.1191 (Ck45)
- Bohrparameter:: Schnittgeschwindigkeit v_{c} =120 m/min
Zahnvorschub f_{z} = 0,2 mm/Umdrehung
Bohrlochtiefe z = 34 mm (5xD)
- Kühlung:: Emulsion 5%
- Prozess:: Sackloch
- Verschleisskriterium:: Eckenverschleiss VB = 0,2 mm

| **Experiment Nr.** | **Schichtdicke [µm]** | **Standweg** [m]** |
|---|---|---|
| 1 AlCrN + TiSiN | 3.9 | 54.3 |
| 2 AlCrN + 2 x Schichtpaket 1^{*} + TiSiN | 4.2 | 43.9 |
| 3 AlCrN + 4 x Schichtpaket 1^{*} + TiSiN | 3.9 | 65.2 |
| 4 AlCrN + 8 x Schichtpaket 1^{*} + TiSiN | 4.0 | 76.2 |
| 5 AlCrN +12 x Schichtpaket 1^{*} + TiSiN | 4.0 | 54.3 |
| 6 AlCrN +15 x Schichtpaket 1^{*} + TiSiN | 3.9 | 43.9 |

| | | |
|---|---|---|
| * Ein (1x) Schichtpaket entspricht dabei einer einmaligen Abfolge von "AlCrTi-SiN+TiSiN+AlCrTiSiN+AlCrN". ** Bei der eine Verschleissmarkenbreite VB = 0,2 mm erreicht wurde. | | |

Beispiel 1 zeigt einen Vergleich der Standzeiten von beschichteten HM-Bohrem, bei denen eine unterschiedliche Anzahl von Schichtpaketen mit jeweils gleicher Haft-, nämlich AlCrN, und Deckschicht, nämlich TiSiN, aufgebracht wurde. Die Beschichtungszeit der TiSiN- und der AlCrN-Schicht wurde jeweils so angepasst, dass eine Ende eine vergleichbare Gesamtschichtdicke erreicht wurde. Ein Optimum in der Gesamtstandzeit wurde in Experiment Nr.4 gefunden mit einer Gesamtanzahl von 37 Lagen, dass eine klare Verbesserung zum Stand der Technik aus Experiment Nr. 1 zeigt.

### Beispiel 2:

Bohren mit innengekühlten HM-Bohrern in Baustahl

| | |
|---|---|
| Werkzeug: | Bohrer Hartmetall mit Kühlkanälen |
| | Durchmesser D = 6.8 mm |
| Werkstück: | Baustahl DIN 1.1191 (Ck45) |
| Bohrparameter: | Schnittgeschwindigkeit v_{c} = 120 m/min |
| | Zahnvorschub f_{z} = 0,2 mm/Umdrehung |
| | Bohrlochtiefe z = 34 mm (5xD) |
| Kühlung: | Emulsion 5% |
| Prozess: | Sackloch |
| Verschleisskriterium: | Eckenverschleiss VB = 0,2 mm |

| **Experiment Nr.** | **Standweg bei VB = 0,2 mm in Meter** |
|---|---|
| | |
| 6 (TiAlN/TiN-Mehrfachschicht) | 32.3 |
| 8 (TiAlN-Einzelschicht) | 32.3 |
| 9 (AlCrN Einzelschicht) | 65.9 |
| 10 AlCrN + 8 x Schichtpaket 1^{*} + TiSiN | 76.2 |

Beispiel 2 zeigt einen Vergleich der Standzeiten von beschichteten HM-Bohrern. Hier konnte ebenfalls mit der AlCrN/TiSiN-Multilagenschicht gegenüber industriell genutzten Hartstoffschichten von TiAlN/TiN-Multilayer und TiAIN-Monolayer-Beschichtungen eine Verbesserung der Werkzeugstandzeit erzielt werden.

### Beispiel 3:

Bohren mit aussengekühlten HM-Bohrern in Baustahl
- Werkzeug:: Bohrer Hartmetall mit Kühlkanälen
Durchmesser D = 6.8 mm
- Werkstück:: Baustahl DIN 1.1191 (Ck45)
- Bohrparameter:: Schnittgeschwindigkeit v_{c} = 120 m/min
Zahnvorschub f_{z} = 0,2 mm/Umdrehung
Bohrlochtiefe z = 23.8 mm (3.5xD)
- Kühlung:: Emulsion 5%
- Prozess:: Sackloch
- Verschleisskriterium:: Eckenverschleiss VB = 0,15 mm

| **Experiment Nr.** | **Standweg bei VB = 0,15 mm in Meter** |
|---|---|
| | |
| 11 (TiAlN/TiN-Multilagen) | 46.1 |
| 12 (TiAlN-Monolagen) | 42.3 |
| 13 (AlCrN) | 22.6 |
| 14 AlCrN + 8 x Schichtpaket 1^{*} + TiSiN | 61.5 |

Beispiel 3 zeigt einen Vergleich der Standzeiten von beschichteten HM-Bohrern. Hier konnte die AlCrN/TiSiN-Multilagenschicht gegenüber industriell genutzten Hartstoffschichten auf Ti-Al-N-Basis eine Verbesserung der Werkzeugstandzeit erzielt werden.

### Beispiel 4:

Bohren mit innengekühlten HM-Bohrern im Gusseisen (GGG-50)
- Werkzeug:: Bohrer Hartmetall mit Kühlkanälen
Durchmesser D = 6.8 mm
- Werkstück:: Gusseisen mit Kugelgraphit GGG-50
- Bohrparameter:: Schnittgeschwindigkeit v_{c} = 200 m/min
Zahnvorschub f_{z} = 0,3 mm/Umdrehung
Bohrlochtiefe z = 34 mm (5xD)
- Kühlung:: Emulsion 5%
- Prozess:: Sackloch
- Verschleisskriterium:: Eckenverschleiss VB = 0,1 mm

| **Experiment Nr.** | **Standweg bei VB = 0,1 mm in Meter** |
|---|---|
| | |
| 15 (TiAlN/TiN Multilayer) | 57.1 |
| 16 (TiAlN-Monolayer) | 142.8 |
| 17 (AlCrN) | 185.6 |
| 18 AlCrN + 8 x Schichtpaket 1^{*} + TiSiN | 199.9 |

Beispiel 4 zeigt einen Vergleich der Standzeiten von beschichteten HM-Bohrern. Hier konnte ebenfalls mit der AlCrN/TiSiN-Multliagen-Beschichtung gegenüber industriell genutzten Hartstoffschichten von TAlN/TiN-Multilagen-Beschichtung und TiAIN-Monolagen-Beschichtungen eine Verbesserung der Werkzeugstandzeit erzielt werden.

### Beispiel 5:

Bohren mit innengekühlten HM-Bohrern in Baustahl
- Werkzeug:: Bohrer Hartmetall mit Kühlkanälen
Durchmesser D = 6.8 mm
- Werkstück:: Baustahl DIN 1.1191 (Ck45)
- Bohrparameter:: Schnittgeschwindigkeit v_{c} = 120 m/min
Zahnvorschub f_{z} = 0,2 mm/Umdrehung
Bohrlochtiefe z = 34 mm (5xD)
- Kühlung:: Emulsion 5%
- Prozess:: Sackloch
- Verschleisskriterium:: Eckenverschleiss VB = 0,2 mm

| **Experiment Nr.** | **Al at%** | **Cr at%** | **M at%** | **Schichtdicke [µm]** | **Standweg bei VB = 0,2 mm in Meter** |
|---|---|---|---|---|---|
| 19 AlCrWN + 8 x Schichtpaket 2^{*} + TiSiN | 70 | 28 | 2 | 3.8 | 65.8 |
| 20 AlCrWN + 8 x Schichtpaket 2^{*} + TiSiN | 70 | 25 | 5 | 3.4 | 59.3 |
| 21 AlCrNbN + 8 x Schichtpaket 2^{*} + TiSiN | 70 | 25 | 5 | 3.8 | 57.8 |
| 22 AlCrMoN + 8 x Schichtpaket 2^{*} + TiSiN | 70 | 25 | 5 | 4.8 | 61.2 |
| 23 AlCrVN + 8 x Schichtpaket 2^{*} + TiSiN | 70 | 25 | 5 | 4.2 | 68.0 |
| 24 AlCrSiN + 8 x Schichtpaket 2^{*} + TiSiN | 70 | 25 | 5 | 4.0 | 54.4 |

| | | | | | |
|---|---|---|---|---|---|
| * Ein (1x) Schichtpaket 2^{*} entspricht einer einmaligen Schichtabfolge von "AlCrMTi-SiN+TiSiN+AlCrMTiSiN+AlCrMN", wobei M für jeweils eines der Elemente W, Nb, Mo, V oder Si steht. | | | | | |

Beispiel 5 zeigt einen Vergleich der Standzeiten von erfindungsgemäss beschichteten HM-Bohrern auf denen Mehrschichtsysteme mit unterschiedlicher chemischer Zusammensetzung, aber gleicher Deckschicht (TiSiN) abgeschieden wurden. Als chemische Zusammensetzung wurde die Targetzusammensetzung variiert, wobei Al konstant gehalten wurde und Cr partiell durch ein drittes Element ersetzt wurde. Die Prozessparameter bei der Schichtabscheidung wurden analog zu den anderen Experimenten gleich gehalten.

Eine weitere Möglichkeit, ein entsprechendes Schichtpaket herzustellen, ergibt sich, wenn analog zu Fig. 1c entweder die AlCr- bzw. AlCrM-Quellen oder die TiSi-Quelle bzw. Quellen durchgehend betrieben werden und die jeweils andere Quelle bzw. Quellen bei Bedarf dazugeschaltet werden. Insbesondere bei durchgehendem Betrieb der oben erwähnten 4 AlCr- bzw. AlCrM Quellen kann damit die Abscheiderate gesteigert werden und beispielsweise das folgende Schichtsystem abgeschieden werden:
- eine (AlCrTiSi) X Mischschicht
- gefolgt von einer einer weiteren (Al_{y}Cr_{1-y}) X Schicht
- gefolgt von einer weiteren (AlCrTiSi) X Mischschicht
- gefolgt von einer weiteren (Al_{y}Cr_{1-y}) X Schicht.

### Beschreibung der Figuren

Figur 1 zeigt verschiedene Schichtvarianten. In FIG. 1a-c werden drei Varianten diskutiert, wie eine Mehrlagenbeschichtung aufgebaut werden kann.

In FIG. 1a ist eine Abfolge von Schichten mit scharfen Übergängen dargestellt. Ein Schichtsystem (2) wird direkt auf ein zweites Schichtsystem (1) abgeschieden. Dieser Vorgang wird solange wiederholt, bis die gewünschte Gesamtschichtdicke erreicht wird. Als letzte Lage kann eine Deckschicht (3) mit höherer Schichtdicke abgeschieden werden.

In FIG. 1b werden zwischen den Einzelschichten noch Mischschichten (4) abgeschieden, in denen beide Schichtsysteme simultan aufgetragen werden. Auch hier kann zusätzlich eine Deckschicht als letzte Einzellage aufgebracht werden. Die Mischschicht kann entweder dünn als gleitende Übergangsschicht oder dicker mit einem Bereich konstanter Schichtzusammensetzung ausgeführt werden. Eine solche Schicht kann beispielsweise folgende Zusammensetzung aufweisen: Al = 40.7 at%, Cr = 21.2 at%, Ti = 32.8 at% und Si = 5.3 at%. Diese Zusammensetzung ergibt sich, wenn simultan AlCr-Targets mit einer Zusammensetzung von Al=70 at% und Cr=30 at% und TiSi-Targets mit einer Zusammensetzung von Ti=85at% und Si=15at% betrieben werden. Ganz allgemein wird dabei die Zusammensetzung einer Mischschicht mit konstanter Zusammensetzung vorteilhaft in folgendem Bereich eingestellt:

(Al_{1-a-b-c}CrₐTi_{b}Si_{c}) X

wobei 0.18 ≤ a ≤ 0.48; 0.28 ≤ b ≤ 0.4; 0.004 ≤ c ≤ 0.12. Der Aluminiumgehalt wird dabei vorteilhafterweise über 10 at% gehalten. Werden noch zusätzlich wie oben erwähnt weitere Elemente zugegeben, sollte, um eine entsprechende Wirkung zu erreichen, je nach Element eine Mindestkonzentration von 0.5 bis 1 Atomprozent und eine Maximalkonzentration von 15 bis 25 % zugegeben werden.

In FIG 1c wird eine Mehrlagenbeschichtung dadurch abgeschieden, dass ein Schichtsystem (5) während der gesamten Beschichtungszeit aufgetragen wird und das zweite Schichtsystem periodisch durch Einschalten der entsprechenden Beschichtungsquelle dazugemischt wird.

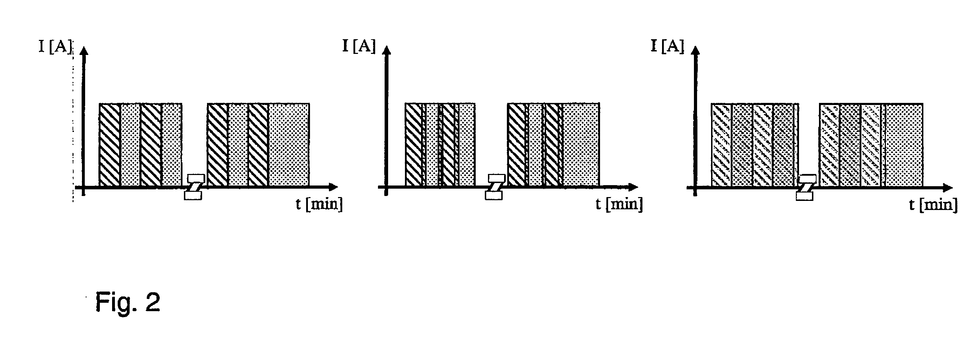

Figur 2 zeigt in geänderter Darstellung den Aufbau der Schichtpakete von Figur 1.

**Tabelle 1**

| ***Versuch*** | ***Kristallstruktur*** | ***Targetzusammensetzung*** | | | | | ***Schichtdicke [µm]*** | ***Haftung*** |
|---|---|---|---|---|---|---|---|---|
| | | ***Target 1*** | | | ***Target 2*** | | | |
| | | ***Al at%*** | ***Cr at%*** | ***M at%*** | ***Ti at%*** | ***Si at%*** | | |
| *A* | *B1* | *70* | *30* | - | *85* | *15* | *4.0* | *HF1* |
| *B* | *B1* | *70* | *28* | *W=2* | *85* | *15* | *3.8* | *HF1* |
| *C* | *B1* | *70* | *25* | *W=5* | *85* | *15* | *3.4* | *HF1* |
| *D* | *B1* | *70* | *25* | *Nb=5* | *85* | *15* | *3.8* | *HF1* |
| *E* | *B1* | *70* | *25* | *V=5* | *85* | *15* | *4.8* | *HF1* |
| *F* | *B1* | *70* | *25* | *Mo=5* | *85* | *15* | *4.2* | *HF1* |
| *G* | *B1* | *70* | *25* | *Si=5* | *85* | *15* | *4.0* | *HF1* |

**Tabelle 2**

| ***Versuch*** | ***P_{Target} Al-Cr-M [kW]*** | ***P_{Target} Ti-Si [kW]*** | ***U_{substrat} [V]*** | ***P_{N2} [Pa]*** | ***Temp. [°C]*** |
|---|---|---|---|---|---|
| *A* | *3* | *3* | *-50* | *3* | *500* |
| *B* | *3* | *3* | *-50* | *3* | *500* |
| *C* | *3* | *3* | *-50* | *3* | *500* |
| *D* | *3* | *3* | *-50* | *3* | *500* |
| *E* | *3* | *3* | *-50* | *3* | *500* |
| *F* | *3* | *3* | *-50* | *3* | *500* |
| *G* | *3* | *3* | *-50* | *3* | *500* |

## Patentansprüche

1. Hartstoffschicht mit Mehrschichtstruktur zur Verbesserung der Verschleissbeständigkeit von Werkstücken umfassend:
- zumindest eine (Al_{y}Cr_{1-y}) X Schicht wobei 0.2 ≤ y ≤ 0.7 und X eines der folgenden Elemente N, C, B, CN, BN, CBN, NO, CO, BO, CNO, BNO, CBNO bevorzugt aber N oder CN ist, und/oder eine (Ti_{z}Si_{1-z}) X Schicht wobei 0.99 ≥ z > 0.7 ist, **dadurch gekennzeichnet, dass** die Hartstoffschicht zusätzlich
- zumindest ein Schichtpaket mit folgendem Aufbau umfasst:
eine (AlCrTiSi) X Mischschicht
gefolgt von einer weiteren (Ti_{z}Si_{1-z}) X Schicht
gefolgt von einer weiteren (AlCrTiSi) X Mischschicht
gefolgt von einer weiteren (Al_{y}Cr_{1-y}) X Schicht.

2. Hartstoffschicht nach Anspruch 1, **dadurch gekennzeichnet, dass** die zumindest eine (Al_{y}Cr_{1-y}) X Schicht, die weiteren (Al_{y}Cr_{1-y}) X Schicht, sowie die (AlCrTiSi) X Mischschichten zumindest ein weiteres Element der Gruppe IVb, Vb und/oder VIb des Periodensystems der Elemente, oder Silizium enthält.

3. Hartstoffschicht nach Anspruch 1 und/oder 2, **dadurch gekennzeichnet, dass** die zumindest eine (Al_{y}Cr_{1-y}) X Schicht sowie die weitere (Al_{y}Cr_{1-y}) X Schicht 0.5 bis 25 Atom% des weiteren Elements oder Siliziums enthalten, wodurch die Konzentration der Elemente und des Siliziums in der weiteren (AlCrTiSi) X Mischschichten festgelegt ist.

4. Hartstoffschicht nach einem der vorhergehenden Ansprüche, **dadurch gekennzeichnet, dass** die Schichten des Schichtpakets folgende Schichtdicken aufweisen:
- Al_{y}Cr_{1-y}N zwischen 75 nm und 200 nm
- Ti_{z}Si_{1-z}N zwischen 50 und 150 nm
- (AlCrTiSi) X Mischschichten 20 ± 10 nm.

5. Hartstoffschicht nach einem der vorhergehenden Ansprüche, **dadurch gekennzeichnet, dass** die Schicht mehrere aufeinanderfolgende Schichtpakete umfasst.

6. Hartstoffschicht nach Anspruch 5, **dadurch gekennzeichnet, dass** das Schichtpaket 4, 8 oder 12, bevorzugt aber 8 Schichtpakete umfasst.

7. Hartstoffschicht nach einem der vorhergehenden Ansprüche, **dadurch gekennzeichnet, dass** zumindest eine (Al_{y}Cr_{1-y}) X Schicht direkt auf dem Werkstück oder auf einer Haftschicht abgelegt ist.

8. Hartstoffschicht nach einem der vorhergehenden Ansprüche, **dadurch gekennzeichnet, dass** eine (Al_{y}Cr_{1-y}) X Deckschicht oder eine (Ti_{z}Si_{1-z}) X Deckschicht die Hartstoffschicht abschliessen.

9. Hartstoffschicht nach einem der vorhergehenden Ansprüche, **dadurch gekennzeichnet, dass** eine zusätzliche Gleitschicht auf der Hartstoffschicht abgelegt ist.

10. Hartstoffschicht nach einem der vorhergehenden Ansprüche, **dadurch gekennzeichnet, dass** das mindestens eine Schichtpaket folgenden Aufbau umfasst:
- eine (AlCrTiSi) X Mischschicht
- gefolgt von einer einer weiteren (Al_{y}Cr_{1-y}) X Schicht
- gefolgt von einer weiteren (AlCrTiSi) X Mischschicht
- gefolgt von einer weiteren (Al_{y}Cr_{1-y}) X Schicht.

11. Hartstoffschicht nach einem der vorhergehenden Ansprüche, **dadurch gekennzeichnet, dass** die Mischschichten eine Multilagenstruktur enthalten.

12. Werkstück, **dadurch gekennzeichnet, dass** das Werkstück eine Beschichtung nach einem der vorhergenden Ansprüche umfasst.

13. Werkstück nach Anspruch 12, **dadurch gekennzeichnet, dass** das Werkstück ein Bauteile für den Maschinen- und Formenbau, ein Werkzeug, ein Zerspanungswerkzeug, ein Schneid- oder Formwerkzeuge bevorzugt aber ein Bohrer ist.

## Claims

1. Hard coating with a multilayer structure for improving the wear resistance of workpieces, comprising:
- at least one (Al_{y}Cr_{1-y}) X layer where 0.2 ≤ y ≤ 0.7 and X is one of the following elements: N, C, B, CN, BN, CBN, NO, CO, BO, CNO, BNO, CBNO but preferably N or CN, and/or a (Ti_{z}Si_{1-z})X layer where 0.99 ≥ z > 0.7, **characterized in that** the hard coating further comprises
- at least one layer package with the following structure:
a (AlCrTiSi)X mixed layer
followed by a further (Ti_{z}Si_{1-z})X layer
followed by a further (AlCrTiSi)X mixed layer
followed by a further (Al_{y}Cr_{1-y})X layer.

2. Hard coating according to claim 1, **characterized in that** the at least one (Al_{y}Cr_{1-y})X layer, the further (AlyCr_{1-y})X layer, as well as the (AlCrTiSi)X mixed layer incorporate at least one further element from the group IVb, Vb and/or VIb of the periodic table of the elements, or silicon.

3. Hard coating according to claim 1 and/or 2, **characterized in that** the at least one (Al_{y}Cr_{1-y})X layer as well as the further (Al_{y}Cr_{1-y})X layer incorporate 0.5-25 at% of the further element or silicon, by which the concentration of the elements and of the silicon in the further (AlCrTiSi)X mixed layer is determined.

4. Hard coating according to one of the preceding claims, **characterized in that** the layers of the layer package exhibit the following layer thicknesses:
- Al_{y}Cr_{1-y}N between 75nm and 200nm
- Ti_{z}Si_{1-z}N between 50 and 150nm
- (AlCrTiSi)X mixed layer 20 ± 10nm.

5. Hard coating according to one of the preceding claims, **characterized in that** the coating comprises a plurality of consecutive layer packages.

6. Hard coating according to claim 5, **characterized in that** the layer package comprises 4, 8 or 12, but preferably 8, layer packages.

7. Hard coating according to one of the preceding claims, **characterized in that** at least one (Al_{y}Cr_{1-y})X layer is deposited directly on the workpiece or on an adhesion layer.

8. Hard coating according to one of the preceding claims, **characterized in that** a (Al_{y}Cr_{1-y})X cover layer or a (Ti_{z}Si_{1-z})X cover layer closes the hard coating.

9. Hard coating according to one of the preceding claims, **characterized in that** an additional sliding layer is deposited on the hard coating.

10. Hard coating according to one of the preceding claims, **characterized in that** at least one layer package comprises the following structure:
- a (AlCrTiSi)X mixed layer
- followed by a further (Al_{y}Cr_{1-y})X layer
- followed by a further (AlCrTiSi)X mixed layer
- followed by a further (Al_{y}Cr_{1-y})X layer.

11. Hard coating according to one of the preceding claims, **characterized in that** the mixed layers incorporate a multilayer structure.

12. Workpiece, **characterized in that** the workpiece comprises a coating according to one of the preceding claims.

13. Workpiece according to claim 12, **characterized in that** the workpiece is a component part for mechanical engineering or toolmaking, a tool, a machining tool, a cutting or forming tool, but preferably a drill.

## Revendications

1. Revêtement dur avec structure multicouches pour améliorer la résistance à l'usure d'une pièce, comprenant:
- au moins une couche de (Al_{y}Cr_{1-y})X où 0.2 ≤ y ≤ 0.7 et X est l'un des éléments suivants: N, C, B, CN, BN, CBN, NO, CO, BO, CNO, BNO, CBNO mais de préférence N ou CN, et/ou une couche de (Ti_{z}Si_{1-z})X où 0.99 ≥ z > 0.7, **caractérisé en ce que** le revêtement dur comprend en outre
- au moins un paquet de couches ayant la structure suivante:
une couche mixte de (AlCrTiSi)X
suivi par une couche de (Ti_{z}Si_{1-z})X supplémentaire suivie par une couche mixte de (AlCrTiSi)X supplémentaire
suivie par une couche de (Al_{y}Cr_{1-y})X supplémentaire.

2. Revêtement dur selon la revendication 1, **caractérisé en ce que** l'au moins une couche de (Al_{y}Cr_{1-y})X, la couche de (Al_{y}Cr_{1-y})X supplémentaire, ainsi que la couche mixte de (AlCrTiSi)X incorporent au moins un élément supplémentaire de la groupe IVb, Vb et/ou VIb du tableau périodique des éléments, ou le silicium.

3. Revêtement dur selon la revendication 1 et/ou 2, **caractérisé en ce que** l'au moins une couche de (Al_{y}Cr_{1-y})X ainsi que la couche de (Al_{y}Cr_{1-y})X supplémentaire incorporent 0.5-25 at% de l'élément supplémentaire ou du silicium, par lequel la concentration des éléments et du silicium dans la couche mixte de (AlCrTiSi)X supplémentaire est déterminée.

4. Revêtement dur selon l'une des revendications précédentes, **caractérisé en ce que** les couches du paquet de couches présentent les épaisseurs de couche suivantes:
- Al_{y}Cr_{1-y}N entre 75nm et 200nm
- Ti_{z}Si_{1-z}N entre 50 et 150nm
- couche mixte de (AlCrTiSi)X 20 ± 10nm.

5. Revêtement dur selon l'une des revendications précédentes, **caractérisé en ce que** le revêtement comprend une pluralité de paquets de couches consécutifs.

6. Revêtement dur selon la revendication 5, **caractérisé en ce que** le paquet de couches comprend 4, 8 ou 12, mais de préférence 8, paquets de couches.

7. Revêtement dur selon l'une des revendications précédentes, **caractérisé en ce qu'**au moins une couche de (Al_{y}Cr_{1-y})X est déposée directement sur la pièce ou sur une couche d'accrochage.

8. Revêtement dur selon l'une des revendications précédentes, **caractérisé en ce qu'**une couche de couverture de (Al_{y}Cr_{1-y})X ou de (Ti_{z}Si_{1-z})X ferme le revêtement dur.

9. Revêtement dur selon l'une des revendications précédentes, **caractérisé en ce qu'**une couche de glissement est déposée sur le revêtement dur.

10. Revêtement dur selon l'une des revendications précédentes, **caractérisé en ce qu'**au moins un paquet de couches comprend la structure suivante:
- une couche mixte de (AlCrTiSi)X
- suivie par une couche de (Al_{y}Cr_{1-y})X supplémentaire
- suivie par une couche mixte de (AlCrTiSi)X supplémentaire
- suivie par une couche de (Al_{y}Cr_{1-y})X supplémentaire.

11. Revêtement dur selon l'une des revendications précédentes, **caractérisé en ce que** les couches mixtes comprennent une structure multicouche.

12. Pièce, **caractérisée en ce que** la pièce comprend un revêtement selon l'une des revendications précédentes.

13. Pièce selon la revendication 12, **caractérisée en ce que** la pièce est un composant pour le génie mécanique ou pour l'outillage, un outil, un outil d'usinage, un outil de coupe ou de moulage, mais de préférence un foret.
